# FASCICULE DE BREVET EUROPEEN

(11) **EP 0 949 666 B1**
(45) Date de publication et mention de la délivrance du brevet: **05.07.2006**
(21) Numéro de dépôt: 99410028.7
(22) Date de dépôt: 31.03.1999
(51) Int. Cl.: H01L 21/331, H01L 29/10

(54) **Région de base-émetteur d'un transistor bipolaire submicronique**
Basis-Emitter Gebiet von einem Submikrometer-Bipolartransistor
Base emitter region of a submicron bipolar transistor

(30) Priorité: 31.03.1998 FR 9804206
(43) Date de publication de la demande: 13.10.1999
(73) Titulaire: STMicroelectronics S.A., 92120 Montrouge (FR); FRANCE TELECOM, 75015 Paris (FR)
(72) Inventeur: Gris, Yvon, 38210 Tullins (FR)
(74) Mandataire: de Beaumont, Michel

(56) Documents cités:
- EP-A- 0 421 507
- EP-A- 0 746 032
- EP-A- 0 766 295
- EHINGER K ET AL: "NARROW BF2 IMPLANTED BASES FOR 35 GHZ / 24 PS HIGH-SPEED SI BIPOLAR TECHNOLOGY" PROCEEDINGS OF THE INTERNATIONAL ELECTRON DEVICES MEETING, WASHINGTON, DEC. 8 - 11, 1991,8 décembre 1991, pages 91/459-462, XP000342178 INSTITUTE OF ELECTRICAL AND ELECTRONICS ENGINEERS

## Description

La présente invention concerne la fabrication d'un transistor bipolaire dans une filière de fabrication de circuits intégrés susceptibles de contenir notamment des composants bipolaires et des composants MOS complémentaires (CMOS).

La présente invention concerne plus particulièrement une telle filière dans laquelle les dimensions d'un élément dessiné sur un masque peuvent être inférieures ou égales à 0,4 µm par exemple de 0,2 à 0,35 µm.

Le document EHINGER K ET AL: "NARROW BF2 IMPLANTED BASES FOR 35 GHZ / 24 PS HIGH-SPEED SI BIPOLAR TECHNOLOGY" PROCEEDINGS OF THE INTERNATIONAL ELECTRON DEVICES MEETING, WASHINGTON, DEC. 8- 11, 1991, 8 décembre 1991, pages 91/459-462, XP000342178 INSTITUTE OF ELECTRICAL AND ELECTRONICS ENGINEERS) décrit un procédé de fabrication d'un transistor bipolaire utilisant des espaceurs comprenant du nitrure de silicium.

Le document EP-A-0766295 décrit la structure d'un transistor bipolaire comprenant une région de base intermédiaire et des espaceurs comprenant du nitrure de silicium.

Une filière de type BICMOS à laquelle s'applique l'invention est décrite dans les demandes de brevets français

FR-A-2756099, FR-A-2756100, FR-A-2756103, FR-A-2756101, FR-A-2756104, FR-A-2757683, FR-A-2758004, FR-A-2774509. Ces demandes n'étant pas publiées à la date de priorité, elles ne font pas partie de l'état de la technique.

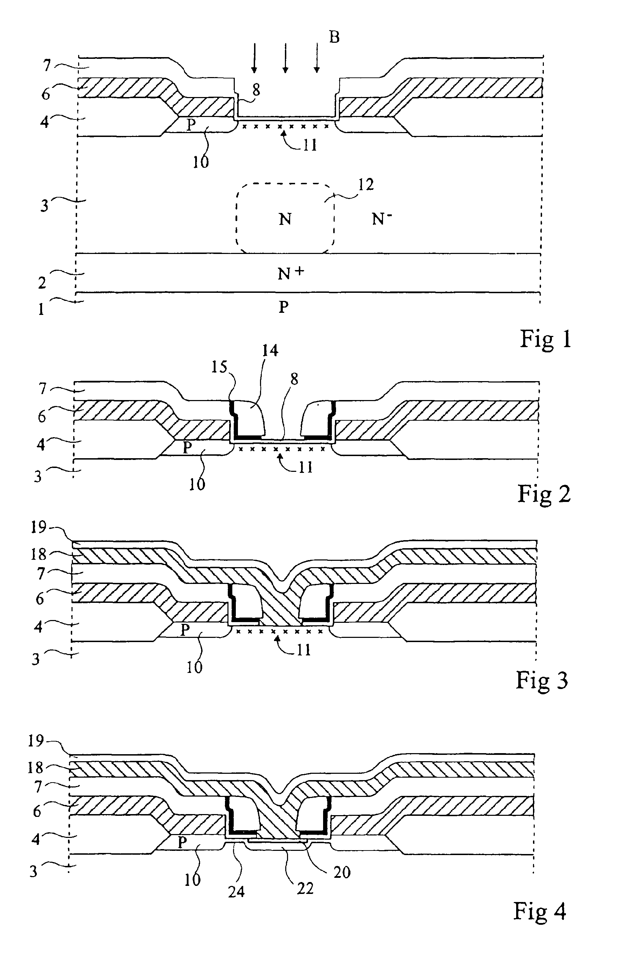

On va indiquer ci-après, en relation avec les vues en coupe simplifiées des figures 1 à 4, l'état de la technique interne concernant la structure d'un transistor bipolaire dans une telle filière.

Comme l'illustre la figure 1, la structure est formée dans un substrat 1 de type P comportant une couche enterrée 2 de type N⁺ sur laquelle est formée une couche épitaxiée 3 de type N faiblement dopée. Une zone active est délimitée par une région d'oxyde 4. Au-dessus de la zone active, on dépose successivement une couche 6 de silicium polycristallin dopé de type P et une couche d'oxyde de protection 7. L'ensemble des couches 6 et 7 est ouvert au niveau de la partie centrale de la zone active. On notera que, lors de la gravure des couches 6 et 7, on creuse inévitablement légèrement la surface supérieure apparente de la couche épitaxiée 3. Après quoi, on procède à une oxydation thermique pour former une couche mince d'oxyde 8, ayant par exemple une épaisseur de l'ordre de 5 nm sur les côtés de la couche de silicium polycristallin 6 et sur la surface de la zone centrale de la couche épitaxiée. Lors de cette étape, les dopants de type P contenus dans le silicium polycristallin 6 diffusent dans la couche épitaxiée 3 pour former une région de base extrinsèque 10. Ensuite, on procède à une implantation d'un dopant de type P, par exemple du bore, la zone implantée, marquée de croix, étant désignée par la référence 11. En outre, préalablement à l'implantation de bore, on réalise de préférence une implantation de type N à très forte énergie pour former une région inférieure de collecteur 12 plus dopée que la couche épitaxiée 3.

De façon classique, le contact de collecteur est repris par une région diffusée de type N⁺, non représentée, venant en contact avec la couche enterrée 2 et remontant jusqu'au niveau de la surface. Cette structure de collecteur ne sera pas représentée et décrite dans la suite de la présente description étant donné qu'elle est bien classique.

A l'étape suivante, illustrée en figure 2, on forme des espaceurs composites. Ces espaceurs sont formés en déposant une couche mince de nitrure de silicium puis une couche de silicium polycristallin. Après gravure anisotrope du silicium polycristallin, il reste seulement des espaceurs de silicium polycristallin 14. Après quoi, on grave le nitrure de silicium et il reste seulement des portions de nitrure de silicium 15 sous le silicium polycristallin.

L'avantage de la formation de tels espaceurs composites par rapport à la formation classique d'espaceurs d'oxyde ou d'espaceurs de nitrure seulement est que l'on obtient une bonne isolation et qu'il est possible de définir des dimensions très précises. La largeur des espaceurs composites est fixée essentiellement par l'épaisseur du silicium polycristallin. La gravure du silicium polycristallin se fait par plasma avec arrêt sur la couche de nitrure qui a par exemple une épaisseur de 30 nm. La gravure du nitrure se fait chimiquement avec arrêt sur la couche d'oxyde. La sélectivité étant extrêmement élevée, il n y a pas de consommation des oxydes 7 et 8. La gravure de l'oxyde de silicium se fait ensuite chimiquement et n'entraîne aucune consommation du silicium. Après cette étape, on dépose une couche de silicium polycristallin 18 fortement dopé de type N, cette couche étant de préférence revêtue d'une couche d'oxyde de silicium 19. On obtient ainsi la structure illustrée en figure 3.

Ensuite, on procède à un recuit thermique rapide, par exemple à 1040°C pendant une durée de 40 s pour obtenir une structure diffusée du type de celle illustrée en figure 4. On obtient ainsi, une région d'émetteur 20 diffusée à partir du silicium polycristallin 18 et formée dans une région de base de type P résultant de la diffusion de la zone implantée 11. Quand on considère plus en détail la base, on peut la diviser en trois régions, la région de base extrinsèque 10 résultant de la diffusion à partir du silicium polycristallin 6 dopé de type P, une région de base intrinsèque 22 sous la région d'émetteur 20 et une région intermédiaire 24 entre les régions de base intrinsèque et extrinsèque, sous l'espaceur composite.

A priori, on aurait pu s'attendre à ce que la région intermédiaire 24 ait diffusé comme la région intrinsèque 22 puisque ces deux régions résultent de la même implantation 11. En fait, on s'aperçoit que la région 24 diffuse beaucoup moins profondément et donc reste beaucoup plus concentrée. Diverses raisons peuvent être avancées pour expliquer ce phénomène vraisemblablement lié à la présence de l'espaceur de nitrure de silicium 14 au-dessus de la région 24. Ceci pourrait paraître favorable puisque le niveau de dopage relativement élevé de la région 24 par rapport à la région 22 tend à réduire la résistance d'accès à la base. Toutefois, étant données les très faibles dimensions d'un composant selon la présente invention, l'étendue latérale homogène de la région 24 est en pratique de l'ordre de seulement 50 à 80 nm et sa résistance est de toute manière faible devant celle des autres éléments résistifs, parasites, de la structure. Par contre, le fait qu'une région à plus forte densité de dopage se trouve au voisinage du bord de la jonction 20 tend à détériorer les caractéristiques courant-tension en direct de la jonction base-émetteur, et donc à réduire le gain du transistor.

Un objet de la présente invention est de prévoir un procédé de fabrication modifié permettant d'améliorer les caractéristiques de la jonction émetteur-base d'un transistor bipolaire.

Un autre objet de la présente invention est de prévoir un tel procédé modifié qui n'augmente pas le nombre d'étapes de masquage et de gravure par rapport au procédé antérieur.

Pour atteindre ces objets, la présente invention prévoit un procédé de fabrication des régions de base et d'émetteur d'un transistor bipolaire dans une zone active d'un premier type de conductivité, comprenant les étapes consistant à déposer une première couche de silicium polycristallin fortement dopée du deuxième type de conductivité ; éliminer la première couche de silicium polycristallin dans sa partie centrale ; faire croître une couche d'oxyde thermique ; procéder à une implantation du deuxième type de conductivité à une première dose ; former des espaceurs de nitrure de silicium à la périphérie interne de la première couche de silicium polycristallin ; procéder à une deuxième implantation du deuxième type de conductivité à une deuxième dose ; éliminer la couche d'oxyde centrale ; déposer une deuxième couche de silicium polycristallin du premier type de conductivité ; et procéder à un recuit thermique rapide ; dans lequel la deuxième dose est sélectionnée pour optimiser les caractéristiques de la jonction base-émetteur et la première dose est inférieure à la deuxième dose.

Selon un mode de réalisation de la présente invention, le premier type de conductivité est le type N et le deuxième type de conductivité est le type P.

Selon un mode de réalisation de la présente invention, la première dose résulte d'une implantation de bore (B¹¹) et la deuxième dose résulte d'une implantation de fluorure de bore (BF₂).

Selon un mode de réalisation de la présente invention, la première implantation est réalisée à une dose de 0,7 à 1 10¹³ at. /cm² sous une énergie de 5 keV et la deuxième implantation est réalisée à une dose de l'ordre de 3 à 5 10¹³ at./cm² sous une énergie de 25 keV.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 4 sont des vues en coupe schématiques d'un composant semiconducteur illustrant des étapes successives de fabrication de la zone d'émetteur-base d'un transistor bipolaire ;
les figures 5 et 6 illustrent des étapes successives d'une variante selon la présente invention du procédé de la figure 1 de fabrication de la zone d'émetteur-base d'un transistor bipolaire ; et
la figure 7 représente de façon schématique et agrandie une partie de la structure de la figure 6, avec indication d'exemples de dimensions.

Le procédé selon la présente invention part des mêmes étapes initiales que celles décrites et illustrées en relation avec les figures 1 et 2.

Toutefois, à l'étape de la figure 1, la dose de dopant de type P, désignée par la référence 30, est choisie plus faible que la dose normale de formation de la base d'un transistor bipolaire - par exemple une implantation de bore B¹¹ à une dose de 0,7 à 1 10¹³ atomes/cm² au lieu d'une implantation de bore B¹¹ à une dose de 3 10¹³ atomes/cm². Ensuite, après l'étape de la figure 2, avant de procéder à l'enlèvement de la couche d'oxyde mince 8 au-dessus de la surface apparente de la couche épitaxiée 3, on procède d'abord à une implantation complémentaire de type P désignée par la référence 31, cette implantation ayant cette fois la dose nécessaire à la formation de la base du transistor bipolaire.

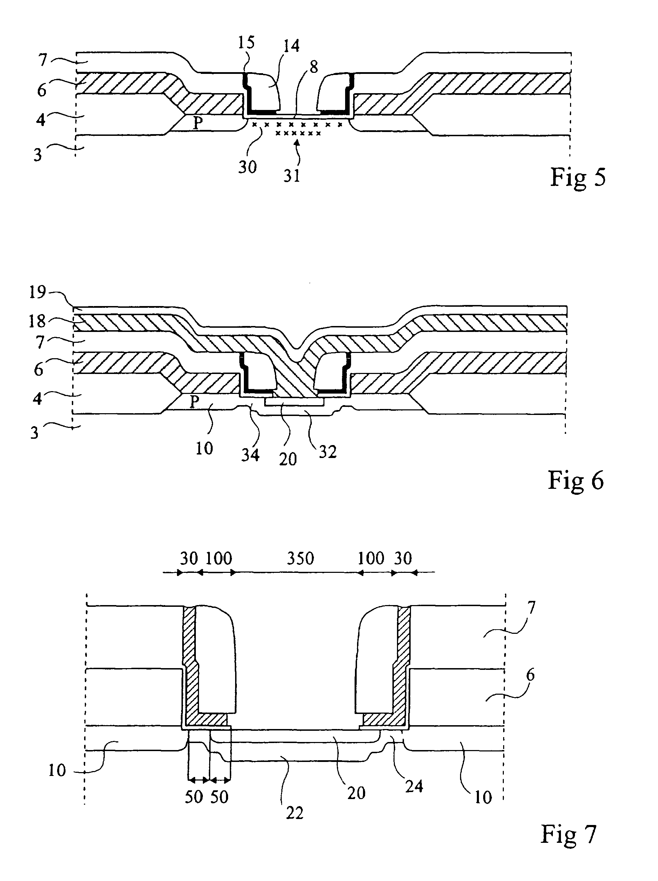

Les étapes ultérieures sont les mêmes que celles décrites et illustrées en relation avec les figures 3 et 4. On notera toutefois après le recuit thermique rapide, le résultat illustré très schématiquement en relation avec la figure 6. La région de base extrinsèque 10, la région de base intrinsèque 32, et la région d'émetteur 20 sont sensiblement les mêmes que celles décrites en relation avec la figure 4. Toutefois, la région de base intermédiaire 34 est bien évidemment moins dopée que la région 24 de la figure 4 puisqu'elle résulte d'une dose d'implantation plus faible. De plus, la région de base intrinsèque 32 peut être considérée, dans sa partie la plus dopée, comme s'étendant seulement en dessous de la région d'émetteur 20 qui en déborde latéralement. De ce fait, l'implantation de base intrinsèque, qui ne remonte plus jusqu'à la surface le long des bords de la région d'émetteur, peut être optimisée pour assurer un gradient de dopage élevé sans risquer de nuire aux caractéristiques de la périphérie de jonction. Ceci permet d'obtenir un transistor à vitesse dynamique élevée et à faible bruit. On s'assure donc ainsi que les courants émetteur-base seront beaucoup plus faibles et que le gain du transistor sera plus élevé.

La figure 7 illustre de façon agrandie mais encore schématique et simplifiée la partie centrale de la figure 6. Des exemples de dimensions, en nanomètres, ont été indiqués sur cette figure. On notera que dans le domaine de réalisation illustré, la largeur de l'ouverture dans l'espaceur composite peut être de 350 nm, la largeur de la base intrinsèque de 350 nm et la largeur de la base intermédiaire entre la base intrinsèque et la base extrinsèque de seulement 50 nm. De préférence, la première implantation, qui correspondra à la phase intermédiaire, est une implantation de bore B¹¹ à une dose de 0,7 à 1 10¹³ atomes/cm² sous une énergie de 5 keV. La deuxième implantation est de préférence une implantation de BF₂, ce qui permet d'obtenir des atomes de bore qui diffusent moins, à une dose de l'ordre de 3 à 5 10¹³ atomes/cm² sous une énergie de 25 keV. La profondeur de pénétration des atomes de bore est la même dans les deux cas. L'implantation de fluorure de bore permet d'une part de réduire la diffusion lors des recuits et donc d'obtenir un gradient de diffusion important de la base intrinsèque et, d'autre part, du fait qu'elle peut être réalisée à une énergie plus élevée, d'être mieux contrôlable. On notera qu'une implantation unique de BF₂ dans le procédé de l'art antérieur aurait encore dégradé le système puisqu'il aurait tendu à fournir une zone de base intermédiaire qui diffuse encore moins et qui aurait été encore plus concentrée.

Bien que la présente invention ait été décrite dans le cadre d'un mode de réalisation particulier et d'une séquence d'étapes bien définies, elle s'applique plus généralement à la réalisation d'un transistor bipolaire de petites dimensions. Les caractéristiques essentielles de la présente invention sont que l'on prévoit une zone de base intrinsèque située strictement sous une zone d'émetteur qui en déborde latéralement, une zone périphérique intermédiaire plus faiblement dopée que la zone de base intrinsèque, et une deuxième zone périphérique plus fortement dopée de base extrinsèque. La présente invention s'applique notamment dans le cas où la zone de base intermédiaire est située sous un espaceur de nitrure.

## Revendications

1. Procédé de fabrication des régions de base et d'émetteur d'un transistor bipolaire dans une zone active d'un premier type de conductivité, comprenant les étapes suivantes :
déposer sur la zone active une première couche de silicium polycristallin (6) fortement dopée du deuxième type de conductivité ;
éliminer la première couche de silicium polycristallin dans sa partie centrale ;
faire croître une couche d'oxyde thermique (8) ;
procéder à une implantation (30) du deuxième type de conductivité à une première dose ;
former des espaceurs de nitrure de silicium (15) à la périphérie interne de la première couche de silicium polycristallin ;
procéder, après la formation des espaceurs, à une deuxième implantation du deuxième type de conductivité (31) à une deuxième dose ;
éliminer la partie centrale de la couche d'oxyde ;
déposer une deuxième couche de silicium polycristallin du premier type de conductivité (18) ; et
procéder à un recuit thermique rapide ;
dans lequel la deuxième dose est sélectionnée pour optimiser les caractéristiques de la jonction base-émetteur et la première dose est inférieure à la deuxième dose.

2. Procédé selon la revendication 1, **caractérisé en ce que** le premier type de conductivité est le type N et le deuxième type de conductivité est le type P.

3. Procédé selon la revendication 1, **caractérisé en ce que** la première dose résulte d'une implantation de bore (B¹¹) et la deuxième dose résulte d'une implantation de fluorure de bore (BF₂).

4. Procédé selon la revendication 3, **caractérisé en ce que** la première implantation est réalisée à une dose de 0,7 à 1 10¹³ atomes/cm² sous une énergie de 5 keV et **en ce que** la deuxième implantation est réalisée à une dose de l'ordre de 3 à 5 10¹³ atomes/cm² sous une énergie de 25 keV.

## Claims

1. A method of manufacturing the base and emitter regions of a bipolar transistor in an active area of a first conductivity type, including the steps of:
depositing on the active area a first heavily-doped polysilicon layer (6) of the second conductivity type;
eliminating the first polysilicon layer in its central portion;
growing a thermal oxide layer (8);
performing an implantation (30) of the second conductivity type at a first dose;
forming silicon nitride spacers (15) at the internal periphery of the first polysilicon layer;
performing, after the formation of the spacers, a second implantation (31) of the second conductivity type at a second dose;
eliminating the central part of the oxide layer;
depositing a second polysilicon layer (18) of the first conductivity type; and
performing a fast thermal anneal;
wherein the second dose is selected to optimize the characteristics of the base-emitter junction and the first dose is smaller than the second dose.

2. The method of claim 1, wherein the first conductivity type is type N and the second conductivity type is type P.

3. The method of claim 1, wherein the first dose results from a boron (B¹¹) implantation and the second dose results from a boron fluoride (BF₂) implantation.

4. The method of claim 3, wherein the first implantation is performed at a dose from 0.7 to 1 10¹³ at./cm² under a 5 keV energy and the second implantation is performed at a dose on the order of 3 to 5 10¹³ at./cm² under a 25 keV energy.

## Patentansprüche

1. Verfahren zur Herstellung der Basis- und Emitterbereiche eines Bipolartransistors in einer aktiven Zone eines ersten Leitfahigkeitstyps, wobei das Verfahren die folgenden Stufen bzw Schritte umfässt:
Abscheiden einer stark dotierten polykristallinen Siliziumschicht (6) des zweiten Leitfähigkeitstyps auf der aktiven Zone;
Entfernen der ersten polykristallinen Siliziumschicht in ihrem mittleren Teil;
Aufwachsen einer thermischen Oxydschicht (8);
Vornahme einer Implantation (30) vom zweiten Leitfähigkeitstyp mit einer ersten Dosis;
Ausbildung von Abstandshalter aus Siliziumnitrid (15) am Innenumfang der ersten polykristallinnen Siliziumschicht;
nach der Ausbildung der Abstandshalter Vornahme einer zweiten Implantation vom zweiten Leitfähigkeitstyp (31) mit einer zweiten Dosis;
Entfernert des mittleren Teils der Oxydschicht;
Abscheiden einer zweiten polykristallinen Siliziumschicht des ersten. Leitfähigkeitstyps (18); sowie
Vornahme einer raschen thermischen Temperung;
wobei in dem Verfahren die zweite Dosis zur Optimierung der Eigenschaften des Basis-Emitter-pn-Obergangs ausgewählt wird und die erste Dosis kleiner als die zweite Dosis ist.

2. Verfahren nach Anspruch 1, **dadurch gekennzeichnet, dass** der erste Leitfähigkeitstyp N-Leitfähigkeit ist und der zweite Leitfähigkeitstyp P-Leitfähigkeit ist

3. Verfahren nach Anspruch 1, **dadurch gekennzeichnet, dass** die erste Dosis das Ergebnis einer Implantation von Bor (B¹¹) ist und dass die zweite Dosis das Ergebnis einen Implantation von Borfluorid (BF₂) ist

4. Verfahren nach Anspruch 3, **dadurch gekennzeichnet, dass** die erste Implantation mit einer Dosis von 0,7 bis 1 10¹³ Atomen / cm² unter einer Energie von 5 keV ausgeführt wird und dass die zweite Implantation mit einer Dosis in der Größenordnung von 3 bis 5 10¹³ Atomen/cm² unter einer Energie von 25 keV ausgeführt wird
